# EUROPÄISCHE PATENTSCHRIFT

(11) **EP 1 440 180 B1**
(45) Veröffentlichungstag und Bekanntmachung des Hinweises auf die Patenterteilung: **26.04.2006**
(21) Anmeldenummer: 02782799.7
(22) Anmeldetag: 27.09.2002
(51) Int. Cl.: C23C 16/455, C30B 25/10, C30B 25/14

(54) **VERFAHREN UND VORRICHTUNG ZUM ABSCHEIDEN INSBESONDERE KRISTALLINER SCHICHTEN AUF INSBESONDERE KRISTALLINEN SUBSTRATEN**
METHOD AND DEVICE FOR DEPOSITING ESPECIALLY CRYSTALLINE LAYERS ONTO ESPECIALLY CRYSTALLINE SUBSTRATES
PROCEDE ET DISPOSITIF POUR DEPOSER EN PARTICULIER DES COUCHES CRISTALLINES NOTAMMENT SUR DES SUBSTRATS CRISTALLINS

(30) Priorität: 30.10.2001 DE 10153463
(43) Veröffentlichungstag der Anmeldung: 28.07.2004
(73) Patentinhaber: Aixtron AG, 52072 Aachen (DE)
(72) Erfinder: FRANKEN, Walter, D-52249 Eschweiler (DE); KÄPPELER, Johannes, 52146 Würselen (DE)
(74) Vertreter: Grundmann, Dirk
(86) Internationale Anmeldenummer: PCT/EP2002/010871
(87) Internationale Veröffentlichungsnummer: WO 2003/038144

(56) Entgegenhaltungen:
- US-A- 3 757 733
- US-A- 5 027 746
- US-A- 5 788 777
- US-B1- 6 289 842
- ZEMBUTSU ET AL: "Growth of GaN single crystal films using electron cyclotron resonance plasma excited metalorganic vapor phase epitaxy" APPLIED PHYSICS LETTERS., Bd. 48, Nr. 13, 31. März 1986 (1986-03-31), Seiten 870-872, XP002231604 AMERICAN INSTITUTE OF PHYSICS. NEW YORK., US ISSN: 0003-6951

## Beschreibung

Die Erfindung betrifft eine Vorrichtung bzw, ein Verfahren zum Abscheiden insbesondere kristalliner Schichten auf insbesondere kristallinen Substraten in einer Prozesskammer, in welcher auf einem Substrathalter mindestens ein Substrat liegt und in welche mittels eines den Substrathalter gegenüberliegenden Gaseinlassorgans Prozessgase eingeleitet werden, wobei aus einer peripheren Austrittsöffnung des Gaseinlassorganes ein erstes Prozessgas und aus einer auf den Substrathalter zuweisenden Stirnseite des Gaseinlassorganes zugeordneten Austrittsöffnung ein zweites Prozessgas austritt.

Eine derartige Vorrichtung bzw. ein Verfahren beschreibt die US 5027746. Betreffend Siliciumcarbid wird diese Vorrichtung von der US 5788777 beschrieben.

Der Erfindung liegt die Aufgabe zugrunde, die bekannte Vorrichtung bzw. das bekannte Verfahren zum Zwecke des Abscheidens von III-V Halbleiterschichten, die auch Stickstoff enthalten, weiter zu bilden. Ein weiteres Ziel der Erfindung betrifft auch Verfahren bzw. Vorrichtungen zum Abscheiden von II-IV-Verbindungen, Oxiden, insbesondere Metall-Oxiden, wobei schwer zerlegbare Ausgangsstoffe eingesetzt werden.

Gelöst wird die Aufgabe die im Anspruch 1 angegebenen Vorrichtung bzw. das im Anspruch 10 angegebene Verfahren, wobei darauf abgestellt ist, dass die Stirnseite des Gaseinlassorganes und der der Stirnseite unnmittelbar gegenüber liegenden Bereich des Substrathalters Elektroden ausbilden, die zur Erzeugung eines kapazitiven Plasmas an einen Hochfrequenzgenerator anschließbar bzw. angeschlossen sind. Zufolge des Hochfrequenzfeldes, welches sich zwischen der Stirnseite des Gaseinlassorganes und der der Stirnseite gegenüber liegenden Elektrode aufbaut, entsteht dort ein Plasma. Dieses Plasma ist in dem Bereich angeordnet, in welchem die Austrittsöffnungen für das zweite Prozessgas liegen. Das zweite Prozessgas kann beispielsweise Ammoniak aufweisen. Im Plasma zerlegt sich das Ammoniak, so dass Stickstoffradikale entstehen. Diese selektive Vorzerlegung der gasförmig zugeführten Stickstoffkomponente hat zur Folge, dass die Prozesskammertemperatur sehr niedrig gehalten werden kann. Sie kann beispielsweise bei 500°C liegen. Zufolge der Trennung der Gaszulässe in eine erste periphere Austrittsöffnung und in eine der Elektrode zugeordneten zweiten Austrittsöffnung entsteht ein selektives Plasma. Die aus der peripheren Austrittsöffnung heraustretenden Gase, welche beispielsweise Trimethylgallium, Trimethylindium oder andere metallorganische Komponenten sind, werden vom Plasma nicht zerlegt. Durch die zentrale Austrittsöffnung, die der Elektrode zugeordnet ist, kann auch eine andere Gruppe V-Komponente in Form eines Hydrids austreten, beispielsweise Arsin oder Phosphin. Auch diese Gase können im Plasma vorzerlegt werden. In einer bevorzugten Weiterbildung der Erfindung ist vorgesehen, dass der Substrathalter von einer Antriebswelle drehantreibbar ist. Diese Antriebswelle kann die Zuleitung zu der vom Zentrum des Substrathalters gebildeten Elektrode zugeordnet sein. Die Elektrode kann sich dann gegenüber der anderen Elektrode drehen. Dies hat die Erzeugung eines symmetrischen Plasmas zur Folge. Der drehantreibbare Substrathalter trägt bevorzugt eine Vielzahl von um sein Zentrum angeordnete, insbesondere auf selbst drehangetriebenen Substratträgerplatten liegende Substrate. Die Substratträgerplatten können auf einem Gaspolster liegen. Die Austrittsdüsen, die zur Ausbildung des Gaspolsters dienen, können so eingerichtet werden, dass sie die Substratträgerplatte in Drehung versetzen. In einer weiteren Ausgestaltung ist vorgesehen, dass die dem Substrathalter zugeordnete Elektrode von einem Spann- bzw. Zugstück gebildet ist, mittels welchem ein ringförmiger Abschnitt des Substrathalters gegen ein Tragelement gedrückt wird. Zwischen dem Spann- bzw. Zugstück kann auch ein ringförmiger Abschnitt angeordnet sein, der als Isolierkörper ausgebildet ist.

Dieser kann beispielsweise aus Quarz bestehen. Die Stirnseite des Gaseinlassorganes, welche die Elektrode bildet, kann eine Metallplatte aufweisen. Diese Metallplatte kann Öffnungen ausbilden, aus denen das aus mehreren Komponenten zusammengesetzte, zweite Prozessgase austreten kann. Rückwärtig dieser Öffnungen endet eine Gaszuleitung. Durch diese Gaszuleitung kann die der Metallplatte zugeordnete elektrische Zuleitung laufen. Diese elektrische Zuleitung kann von einem Stab ausgebildet sein, der in einem Quarzrohr angeordnet ist. Das Quarzrohr ummantelt den Stab, der mit der die Elektrode bildenden Metallplatte verschraubt ist. Der ringförmige Abschnitt des Substrathalters wird in bekannter Weise von unten bzw. rückwärtig von einer Hochfrequenzspule beheizt. Die die Elektroden bildende Metallplatte bzw. das Zugstück können aus Molybdän gefertigt sein. Das Plasma wird von einem Plasmagenerator erzeugt. Der Plasmagenerator erzeugt eine Wechselspannung von beispielsweise 13,56 MHz. Diese Wechselspannung wird kapazitiv über die beiden Elektroden in die Gasphase der Prozesskammer eingekoppelt. Zwischen den Elektroden brennt ein symmetrisches, selektives Plasma, welches nur auf das Hydrid wirkt. Anstelle von Ammoniak können auch andere Stickstoffverbindungen verwendet werden, beispielsweise Hydrazin oder dergleichen.

Ein Ausführungsbeispiel der Erfindung wird nachfolgend anhand beigefügter Figuren erläutert. Es zeigen:
- Fig.1: in Querschnitt einer Prozesskammer mit den beiden Elektroden und die elektrischen Zuleitungen zu den Elektroden in grob-schematisierter Schnittdarstellung,

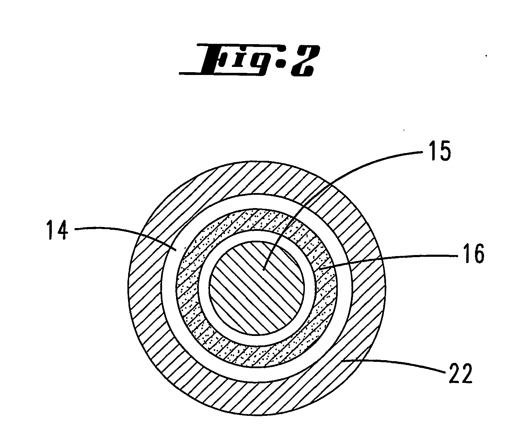

- Fig. 2: einen Schnitt gemäß der Linie II-II in Fig.1,

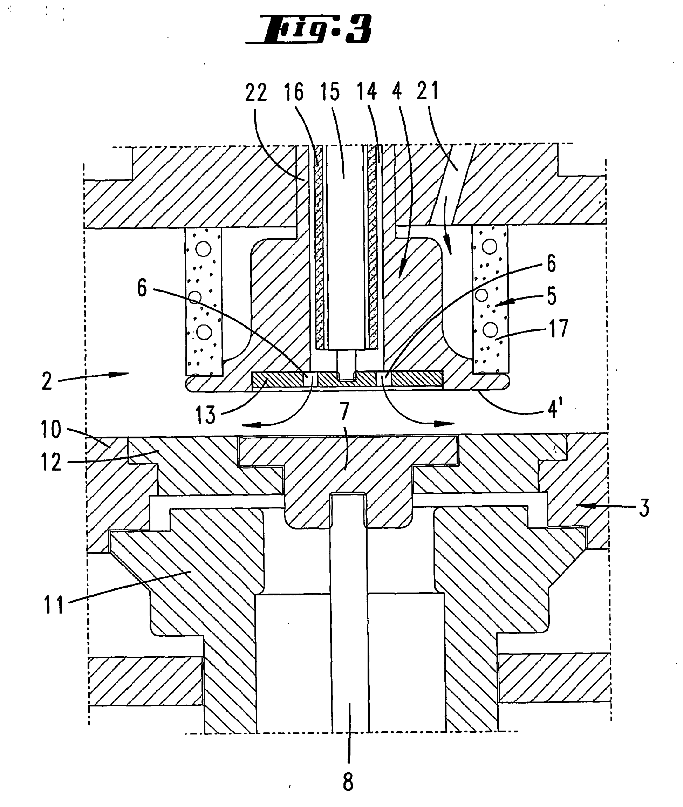

- Fig. 3: eine vergrößerte Darstellung des Bereichs der Prozesskammer, in welcher die Elektrode angeordnet sind,
- Fig. 4: eine vergrößerte Darstellung des Kopfes des Gaseinlasssystems.

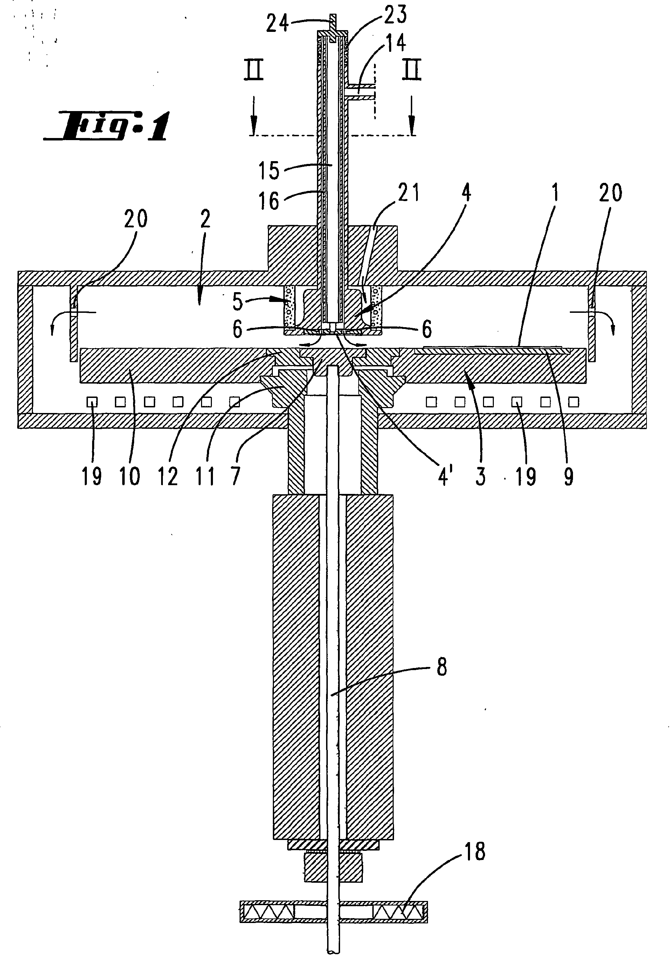

Der in der Fig. 1 grob-schematisch dargestellte Reaktor besitzt eine im Wesentlichen zylindersymmetrische Prozesskammer 2. Der Boden der Prozesskammer 2 wird von einem Substrathalter 3 ausgebildet, welcher aus Graphit oder beschichteten Graphit bestehen kann. Der Substrathalter 3 besitzt einen äußeren, ringförmigen Abschnitt 10, auf welchem eine Vielzahl von Substrathalterplatten 9 angeordnet sind. Die Substrathalterplatten 9 umgeben das Zentrum des ringförmiges Abschnittes planetenartig. Mittels nicht dargestellter Mittel sind die Substrathalterplatten drehantreibbar. Es handelt sich dabei um unterhalb der Substrathalterplatten 9 angeordnete Gasdüsen, aus denen ein gerichteter Gasstrom austritt, welcher einerseits ein Gaspolster ausbildet auf welchem die Substrathalterplatten 9 schweben, und andererseits ein Drehmoment auf die Substrathalterplatten 9 ausübt, so dass sich die Substrathalterplatten 9 um ihre Achsen drehen. Auf den in Aussparungen einliegenden Substrathalterplatten 9 liegt jeweils ein Substrat 1.

Der ringförmige Abschnitt 10 liegt mit seiner inneren Randkante auf einem Tragelement 11. Das Tragelement 11 wird durch nicht dargestellte Mittel mechanisch drehangetrieben. Oberhalb des Tragelementes 11 befindet sich ein ebenfalls ringförmiger Isolierkörper, der auf dem inneren Rand des ringförmigen Abschnittes 10 aufliegt. Auf dem inneren Rand des Isolierkörpers 12 liegt ein Zugstück 7 aus Molybdän auf. Die Oberflächen vom ringförmigem Abschnitt 10, Isolierkörper 12 und Zugstück 7 fluchten miteinander. In eine rückwärtige Einschrauböffnung des Zugstückes 7 ist eine Zugstange 8 eingeschraubt. Diese Zugstange 8 ist Teil einer Antriebswelle, die den Substrathalter 3 drehantreibt.

Gegenüber liegend zum Zugstück 7, welches das Zentrum des Substrathalters 3 bildet, befindet sich ein Gaseinlassorgan 4. Dieses Gaseinlassorgan 4 ragt in die Prozesskammer 2 hinein. Das Gaseinlassorgan 4 besitzt eine periphere Austrittsöffnung 5 in Form eines porösen oder geschlitztes Quarzringes. Aus dieser Austrittsöffnung 5 strömt ein erstes Prozessgas. Es handelt sich dabei um eine metallorganische Verbindung eines Metalles der dritten Hauptgruppe, beispielsweise Trimethylgallium oder Trimethylindium. Rückwärtig dieses porösen Ringes 17 befindet sich eine Gasverteilkammer, in welche durch eine Zuleitung 21 die metallorganische Verbindung und ein Trägergas, bei dem es sich um Wasserstoff oder Stickstoff handeln kann, einströmt.

Die Stirnseite 4' des Gaseinlassorganes 4 trägt eine Metallplatte 13. Diese Metallplatte 13 liegt unmittelbar dem ebenfalls aus Metall bestehenden Zugstück gegenüber. Die Metallplatte 13 besitzt mehrere, insbesondere ringförmig angeordnete Öffnungen 6. In das Zentrum der Metallplatte ist das Außengewinde einer Haltestange 15 eingeschraubt. Die Haltestange 15 ist mittels eines Quarzrohres 16 ummantelt. Außerhalb des Quarzrohres 16 und innerhalb einer Wandung einer Höhlung, in welcher sich das Quarzrohr 16 befindet, strömt das zweite Prozessgas zu den Öffnungen 6. Der Strömungskanal 14 für dieses zweite Prozessgas, bei dem es sich um ein Hydrid handelt, ist ringförmig.

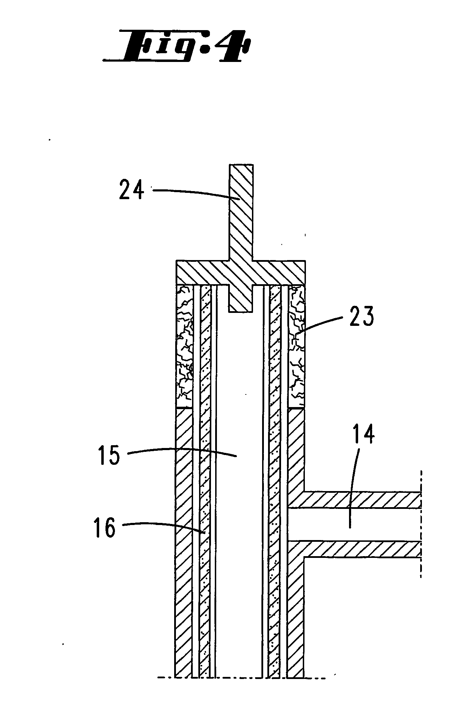

Der Kopf des Gaseinlassorganes 4 ist in der Fig. 4 vergrößert dargestellt. Auf dem Mantelrohr 22 sitzt eine Isolationshülse 23, welche von einem Deckel verschlossen ist. Dieser Deckel bildet einen elektrischen Anschluss 24 für den Plasmagenerator aus. Deckelinnenseitig ist die elektrische Zuleitung 15 befe stigt, beispielsweise mittels einer Gewindeverbindung. Das Quarzrohr 16 stösst mit seinem Stirnende gegen die Innenfläche des Deckels.

Das Prozessgas, welches durch die Zuleitung 14 strömt, beinhaltet eine Stickstoffverbindung, beispielsweise Ammoniak. Dieser Ammoniak tritt durch die Öffnungen 6 in den Zwischenraum zwischen der Metallplatte 13 und dem metallischen Zugstück 7 ein.

An der Metallplatte 13 und dem Zugstück 7 liegt eine Hochfrequenz-Wechselspannung an, beispielsweise von 13,56 MHz. Der Totalgasdruck in der Prozesskammer 2 ist so gewählt, dass zwischen der stillstehenden Metallplatte 13 und dem Zugstück 7 ein symmetrisches Plasma brennt. Es handelt sich dabei um ein kapazitives Plasma. Innerhalb des Plasmas wird die Stickstoffverbindung und beispielsweise Arsin oder Phosphin, welches zusätzlich durch die Gaszuleitung 14 in den Reaktor gebracht wird, vorzerlegt, so dass insbesondere Stickstoffradikale entstehen.

Die elektrische Zuleitung zur Metallplatte 13, welche bevorzugt aus Molybdän besteht, erfolgt über den Stab 15.

Die elektrische Zuleitung zu den ebenfalls vorzugsweise aus Molybdän bestehendem, Zugstück 7 erfolgt über die Zugstange 8. Die Zugstange 8 kann mit ihrem Ende aus der Antriebswelle herausragen. An der Zugstange 8 können Schleifkontakte 18 angreifen, um den elektrischen Strom zu übertragen. Unterhalb des ringförmigen Abschnittes 10 des Substrathalters 3 befindet sich eine Spule 19, welche ebenfalls von Hochfrequenz beaufschlagt wird. Durch induzierte Wirbelströme erwärmt sich der ringförmige Abschnitt 10 des Substrathalters 3.

Um die Prozesskammer 2 erstreckt sich eine Wand, welche Gasauslassöffnungen 20 ausbildet.

Das aus den Öffnungen 6 austretende Prozessgas wird in dem Plasma zwischen den beiden Elektroden 7 und 13 teilzerlegt. Durch radial auswärts strömenden Gasstrom werden die entstandenen Stickstoffradikale zu den Substraten 1 transportiert. Durch die periphere Austrittsöffnung 5 tritt die metallorganische Komponente aus und wird in dem Bereich vor oder oberhalb des Substrates 1 zerlegt. Auf den Substraten 1 wird eine Schicht aus einem III-V-Material, beispielsweise GaAs oder InP abgeschieden. Zugleich wird in die Kristallschicht eine geringe Menge von Stickstoff eingebaut. Es wird als vorteilhaft angesehen, dass sich die Elektroden relativ zueinander drehen.

Die Anordnung des Plasmas zwischen den beiden im Zentrum des Substrathalters 3 angeordneten Elektroden 7 und 13 ist so gewählt, dass das Plasma nur zur Zerlegung derjenigen Gase beiträgt, die aus den Austrittsöffnungen 6 strömen. Das Plasma ist räumlich von den Substraten 1 bzw. den Substrathalterplatten 9 entfernt. Es ist ferner von Vorteil, dass das zu zerlegende Gas in Axialrichtung durch die Austrittsöffnungen 6 in die Zone zwischen den beiden Elektroden 7 und 13 strömt. Das Gas wird in dem Bereich zwischen den Elektroden 7 und 13 umgelenkt, um in Radialauswärtsrichtung das Plasma, welches sich auf den Bereich zwischen den beiden Elektroden 7,13 beschränkt, zu verlassen. Es ist ferner von Vorteil, dass sich die Elektrode 7 relativ gegenüber der dem Gaseinlassorgan 4 zugeordneten Elektrode 13 dreht. Dies hat eine Homogenisierung des Plasmas zur Folge. Indem ferner der gesamte Substrathalter 3 gegenüber dem Gaseinlassorgan 4 und der Elektrode 13 rotiert, wird die Gasverteilung zu den einzelnen Substraten 1 weiter homogenisiert.

Es ist ferner von Vorteil, dass die periphere Austrittsöffnung 5 unmittelbar unter der Prozesskammerdecke angeordnet ist und die axialen Austrittsöffnungen 6 bzw. der Bereich, in welchem das Plasma erzeugt wird, dem Boden der Prozesskammer, also dem Substrathalter 3 unmittelbar benachbart ist.

Konstruktiv vorteilhaft ist es , wenn die obere Zuleitung zur Elektrode 13 über eine Zugstange 15 erfolgt und die Zuleitung zur unteren Elektrode 7 ebenfalls über eine Zugstange 18 erfolgt, wobei beiden Zugstangen über ein Gewinde mit der ihr zugeordneten Elektrode verbunden sind, wobei eine Elektrode von der Metallplatte 13 und die andere Elektrode von einem Zugstück 7 ausgebildet wird.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Vorrichtung zum Abscheiden insbesondere kristalliner Schichten auf insbesondere kristallinen Substraten (1) mit einer Prozesskammer (2) mit einem Substrathalter (3) zur Aufnahme einer Vielzahl von um ein Zentrum des Substrathalters (3) angeordneten Substraten (1) und einem dem Substrathalter (3) gegenüber liegenden Gaseinlassorgan (4) mit einer peripheren Austrittsöffnung (5) für ein erstes Prozessgas und mit einer einer auf den Substrathalter (3) zuweisenden Stirnseite (4') angeordneten Austrittsöffnung für ein zweites Prozessgas, **dadurch gekennzeichnet, dass** die Stirnseite (4') des Gaseinlassorganes und der der Stirnseite (4') unmittelbar gegenüber liegende Bereich (7) des Substrathalters (3) Elektroden ausbilden, die zur Erzeugung eines kapazitiven Plasmas an einen Hochfrequenz-Generator anschließbar bzw. angeschlossen sind, wobei das Plasma auf das von den Substraten (1) entfernt liegende Zentrum des Substrathalters beschränkt ist.

2. Vorrichtung nach Anspruch 1 oder insbesondere danach, **dadurch gekennzeichnet, dass** der Substrathalter (3) zusammen mit der ihm zugeordneten Elektrode (7) drehantreibbar ist und die der drehantreibbaren Elektrode (7) unmittelbar gegenüber liegende Elektrode (6) stillsteht.

3. Vorrichtung nach einem oder mehreren der vorhergehenden Ansprüche oder insbesondere danach, **dadurch gekennzeichnet, dass** der Substrathalter (3) von einer Antriebswelle drehantreibbar ist und die Antriebswelle eine Zugstange aufweist, die auf ein Zugstück (7) wirkt, welches im Zentrum des Substrathalters (3) angeordnet ist, und die eine elektrische Zuleitung zu der vom Zugstück gebildeten Elektrode (7) ist.

4. Vorrichtung nach einem oder mehreren der vorhergehenden Ansprüche oder insbesondere danach, **dadurch gekennzeichnet, dass** der drehantreibbare Substrathalter (3) eine Vielzahl von um sein Zentrum angeordnete, selbst drehangetriebene Substrathalterträgerplatten (9) aufweist zur Aufnahme der Substrate (1) trägt.

5. Vorrichtung nach einem oder mehreren der vorhergehenden Ansprüche oder insbesondere danach, **dadurch gekennzeichnet, dass** die dem Substrathalter (3) zugeordnete Elektrode (7) von einem Zugstück gebildet ist, das einen ringförmigen Abschnitt (10) des Substrathalters gegen ein Tragelement (11) drückt.

6. Vorrichtung nach einem oder mehreren der vorhergehenden Ansprüche oder insbesondere danach, **gekennzeichnet durch** einen zwischen dem Zugstück (7) und dem ringförmigen Abschnitt (10) angeordneten ringförmigen Isolierkörper (12).

7. Vorrichtung nach einem oder mehreren der vorhergehenden Ansprüche oder insbesondere danach, **dadurch gekennzeichnet, dass** die der Stirnseite (4') des Gaseinlassorganes (4) zugeordnete Elektrode (7) eine Gasaustrittsöffnungen (6) aufweisende Metallplatte (13) ist, rückwärtig welcher eine Gaszuleitung (14) endet, durch welche die der Elektrode (7) zugeordnete Zuleitung (15) läuft.

8. Vorrichtung nach einem oder mehreren der vorhergehenden Ansprüche oder insbesondere danach, **dadurch gekennzeichnet, dass** die elektrische Zuleitung (15) als von einem Quarzrohr (16) ummantelter Stab ausgebildet ist, mittels dessen die Elektrodenplatte (13) am Gaseinlassorgan (4) befestigt ist.

9. Vorrichtung nach einem oder mehreren der vorhergehenden Ansprüche oder insbesondere danach, **dadurch gekennzeichnet, dass** der ringförmige Abschnitt (10) rückseitig insbesondere mittels Hochfrequenz (19) beheizbar ist.

10. Verfahren zum Abscheiden insbesondere kristalliner Schichten auf insbesondere kristallinen Substraten (1) in einer Prozesskammer (2), in welcher auf einem Substrathalter (3) mindestens ein Substrat liegt und in welche mittels eines dem Substrathalter (3) gegenüber liegenden Gaseinlassorganes Prozessgase eingeleitet werden, wobei aus einer peripheren Austrittsöffnung (5) ein erstes Prozessgas und aus einer einer auf den Substrathalter (3) zuweisenden Stirnseite (4') des Gaseinlassorganes (4) zugeordneten Austrittsöffnung (6) ein zweites Prozessgas austritt, **gekennzeichnet durch** ein zwischen der Stirnseite (4') des Gaseinlassorganes (4) und der der Stirnseite (4') unmittelbar gegenüber liegende Bereich (7) des Substrathalters (3) erzeugtes kapazitives Plasma zum Zerlegen des aus der Stirnseitenöffnungen (6) austretenden Prozessgases.

11. Verfahren nach einem oder mehreren der vorhergehenden Ansprüche oder insbesondere danach, **dadurch gekennzeichnet, dass** das aus der Stirnseitenöffnung (6) austretende Prozessgas Ammoniak oder eine andere Stickstoffverbindung ist.

12. Verfahren nach einem oder mehreren der vorhergehenden Ansprüche oder insbesondere danach, **dadurch gekennzeichnet, dass** die Prozesstemperatur 500°C ist.

13. Verfahren nach einem oder mehreren der vorhergehenden Ansprüche oder insbesondere danach, **dadurch gekennzeichnet, dass** das aus der Stirnseitenöffnung (6) austretende Prozessgas ein bei niedrigen Temperaturen schwer zerlegbarer Ausgangsstoff für die Abscheidung von Oxiden, insbesondere Metall-Oxiden, ist.

## Claims

1. Device for depositing in particular crystalline layers on in particular crystalline substrates (1), having a process chamber (2) with a substrate holder (3) for accommodating a multiplicity of substrates (1), disposed around a center of the substrate holder (3), and a gas inlet member (4), which is located opposite the substrate holder (3) and has a peripheral outlet opening (5) for a first process gas and an outlet opening for a second process gas disposed at an end face (4') facing the substrate holder (3), **characterized in that** the end face (4') of the gas inlet member and that region (7) of the substrate holder (3) which lies directly opposite the end face (4') form electrodes which, in order to generate a capacitive plasma, are or can be connected to a radio frequency generator, with the plasma being restricted to the center, remote from the substrates (1), of the substrate holder.

2. Device according to claim 1 or in particular according thereto, **characterized in that** the substrate holder (3), together with its associated electrode (7), can be driven in rotation, and the electrode (6) located directly opposite the electrode (7) which can be driven in rotation is stationary.

3. Device according to one or more of the preceding claims or in particular according thereto, **characterized in that** the substrate holder (3) can be driven in rotation by a drive shaft (3), and the drive shaft has a tension rod which acts on a tension piece (7) disposed in the center of the substrate holder (3) and which is an electrical supply to the electrode (7) formed by the tension piece.

4. Device according to one or more of the preceding claims or in particular according thereto, **characterized in that** the substrate holder (3) which can be driven in rotation carries has a multiplicity of substrate holder carrier plates (9), which are disposed about its center and can themselves be driven in rotation, for accommodating the substrates (1).

5. Device according to one or more of the preceding claims or in particular according thereto, **characterized in that** the electrode (7) associated with the substrate holder (3) is formed by a tension piece which presses an annular section (10) of the substrate holder onto a carrying element (11).

6. Device according to one or more of the preceding claims or in particular according thereto, **characterized by** an annular insulating body (12) disposed between the tension piece (7) and the annular section (10).

7. Device according to one or more of the preceding claims or in particular according thereto, **characterized in that** the electrode (7) associated with the end face (4') of the gas inlet member (4) is a metal plate (13) which has gas outlet openings (6) and to the rear of which ends a gas supply line (14), through which the supply associated with the electrode (7) runs.

8. Device according to one or more of the preceding claims or in particular according thereto, **characterized in that** the electrical supply (15) is configured as a rod which is sheathed by a quartz tube (16) and by means of which the electrode plate (13) is secured to the gas inlet member (4).

9. Device according to one or more of the preceding claims or in particular according thereto, **characterized in that** the annular section (10) can be heated at the rear, in particular by means of radio frequency (19).

10. Process for depositing in particular crystalline layers on in particular crystalline substrates (1) in a process chamber (2), in which at least one substrate is located on a substrate holder (3) and into which process gases are introduced by means of a gas inlet member located opposite the substrate holder (3), with a first process gas emerging from a peripheral outlet opening (5) and a second process gas emerging from an outlet opening (6) associated with an end face (4'), facing the substrate holder (3), of the gas inlet member (4), **characterized by** a capacitive plasma, which is generated between the end face (4') of the gas inlet member (4) and that region (7) of the substrate holder (3) which lies directly opposite the end face (4'), for decomposing the process gas which emerges from the end-face openings (6).

11. Process according to one or more of the preceding claims or in particular according thereto, **characterized in that** the process gas emerging from the end-face opening (6) is ammonia or another nitrogen compound.

12. Process according to one or more of the preceding claims or in particular according thereto, **characterized in that** the process temperature is 500°C.

13. Process according to one or more of the preceding claims or in particular according thereto, **characterized in that** the process gas which emerges from the end-face opening (6) is a starting material for the deposition of oxides, in particular metal oxides, which starting material is difficult to decompose at low temperatures.

## Revendications

1. Dispositif de déposition de couches, en particulier cristallines, sur des substrats (1), en particulier cristallins, ledit dispositif comportant une chambre de processus (2) dotée d'un porte-substrat (3), destiné à recevoir un grand nombre de substrats (1) placés autour d'un centre du porte-substrat (3), et un organe d'admission de gaz (4) opposé au porte-substrat (3) et comportant une ouverture de sortie périphérique (5) destinée à un premier gaz de processus et une ouverture de sortie ménagée du côté frontal (4'), dirigé vers le porte-substrat (3), et destinée à un deuxième gaz de processus, **caractérisé en ce que** le côté frontal (4') de l'organe d'admission de gaz et la région (7) du porte-substrat (3), qui est directement opposée au côté frontal (4'), forment des électrodes qui sont raccordées ou raccordables à un générateur à haute fréquence afin de générer un plasma capacitif, le plasma étant limité au centre du porte-substrat qui est à distance des substrats (1).

2. Dispositif selon, ou en particulier selon, la revendication 1, **caractérisé en ce que** le porte-substrat (3) peut être entraîné en rotation conjointement avec l'électrode (7) qui lui est associée et l'électrode (6), qui est directement opposée à l'électrode (7) pouvant être entraînée en rotation, se trouve au repos.

3. Dispositif selon, ou en particulier selon, l'une ou plusieurs des revendications précédentes, **caractérisé en ce que** le porte-substrat (3) peut être entraîné en rotation par un arbre d'entraînement et l'arbre d'entraînement comporte une tige de traction qui agit sur une pièce de traction (7) qui est placée au centre du porte-substrat (3) et qui constitue un conducteur d'alimentation électrique de l'électrode (7) formée par la pièce de traction.

4. Dispositif selon, ou en particulier selon, l'une ou plusieurs des revendications précédentes, **caractérisé en ce que** le porte-substrat (3) pouvant être entraîné en rotation supporte un grand nombre de plaques de support de porte-substrat (9), disposées autour de son centre, entraînées elles-mêmes en rotation et destinées à recevoir les substrats (1).

5. Dispositif selon, ou en particulier selon, l'une ou plusieurs des revendications précédentes, **caractérisé en ce que** l'électrode (7), associée au porte-substrat (3) est formée par une pièce de traction qui presse une portion annulaire (10) du porte-substrat contre un élément de support (11).

6. Dispositif selon, ou en particulier selon, l'une ou plusieurs des revendications précédentes, **caractérisé par** un corps isolant annulaire (12) placé entre la pièce de traction (7) et la portion annulaire (10).

7. Dispositif selon, ou en particulier selon, l'une ou plusieurs des revendications précédentes, **caractérisé en ce que** l'électrode (7) associée au côté frontal (4') de l'organe d'admission de gaz (4) est une plaque métallique (13) qui comporte des ouvertures de sortie de gaz (6) et en arrière de laquelle se termine une conduite d'amenée de gaz (14) qui est traversée par la conduite d'alimentation (15) associée à l'électrode (7).

8. Dispositif selon, ou en particulier selon, l'une ou plusieurs des revendications précédentes, **caractérisé en ce que** la conduite d'alimentation électrique (15) est conformée en barre qui est entourée par un tube de quartz (16) et qui permet de fixer la plaque d'électrode (13) à l'organe d'admission de gaz (4).

9. Dispositif selon, ou en particulier selon, l'une ou plusieurs des revendications précédentes, **caractérisé en ce que** la portion annulaire (10) peut être chauffée à l'arrière en particulier par haute fréquence (19).

10. Procédé de déposition de couches, en particulier cristallines, sur des substrats (1), en particulier cristallins, dans une chambre de processus (2) dans laquelle au moins un substrat est placé sur un porte-substrat (3) et dans laquelle des gaz de processus sont introduits au moyen d'un organe d'admission de gaz opposé au porte-substrat (3), un premier gaz de processus sortant par une première ouverture de sortie périphérique (5) et un deuxième gaz de processus sortant par une ouverture de sortie (6) associée à un côté frontal (4'), dirigé vers le porte-substrat (3), de l'organe d'admission de gaz (4), **caractérisé par** un plasma capacitif généré entre le côté frontal (4') de l'organe d'admission de gaz (4) et la région (7) du porte-substrat (3), qui est directement opposée au côté frontal (4'), afin de décomposer le gaz de processus sortant par les ouvertures (6) ménagées du côté frontal.

11. Procédé selon, ou en particulier selon, l'une ou plusieurs des revendications précédentes, **caractérisé en ce que** le gaz de processus sortant par l'ouverture (6) ménagée du côté frontal est l'ammoniac ou un autre composé azoté.

12. Procédé selon, ou en particulier selon, l'une ou plusieurs des revendications précédentes, **caractérisé en ce que** la température de processus est de 500°C.

13. Procédé selon, ou en particulier selon, l'une ou plusieurs des revendications précédentes, **caractérisé en ce que** le gaz de processus sortant par l'ouverture (6) ménagée du côté frontal est une matière de départ qui est difficilement décomposable à basses températures et qui est destinée à la déposition d'oxydes, en particulier d'oxydes métalliques.
